(19) **Europäisches Patentamt**
**European Patent Office**
**Office européen des brevets**

(11) **EP 4 632 318 A1**

(12) **EUROPEAN PATENT APPLICATION**

(43) Date of publication:
**15.10.2025 Bulletin 2025/42**

(51) International Patent Classification (IPC):
**G01B 11/30** (2006.01)

(21) Application number: **24169471.0**

(22) Date of filing: **10.04.2024**

(52) Cooperative Patent Classification (CPC):
**G01B 11/303**; G01B 2210/56

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Nexgen Wafer Systems Pte. Ltd.**
**569880, Singapore (SG)**

(72) Inventors:
• **IBRAHIM, Hazem**
**9020 Klagenfurt (AT)**
• **HUBER, Martin**
**9500 Villach (AT)**

(74) Representative: **Maiwald GmbH**
**Engineering**
**Elisenhof**
**Elisenstrasse 3**
**80335 München (DE)**

(54) **METHOD FOR DETERMINING A SURFACE ROUGHNESS OF A SPECIMEN SURFACE OF A SPECIMEN**

(57) The disclosure relates to a method (300) for determining a surface roughness of a specimen surface of a specimen (1), the method (300) comprising:
- obtaining several measurement data, each one of the measurement data being indicative of a surface topology of the specimen surface based on an optical three-dimensional measurement of the specimen surface by an image sensor, wherein each one of the measurement data is associated with a different brightness level of a light source illuminating the specimen surface or with a different exposure of the image sensor;
- obtaining first computation data indicative of surface roughnesses of the specimen surface for each one of the measurement data; and
- determining second computation data indicative of a surface roughness of the specimen surface for all measurement data based on the first computation data.

Fig. 1

EP 4 632 318 A1

**Description**

**TECHNICAL FIELD**

The present invention generally relates to the field of determining surface roughness of specimen surfaces of specimens, in particular semiconductor wafers with etched wafer surface. The present invention specifically relates to a method for determining a surface roughness of a specimen surface of a specimen, a computer program product, a data processing system, and a specimen processing system.

**BACKGROUND OF THE INVENTION**

For quality control purposes or other purposes, such as described further below herein, it may be useful to measure the surface roughness of a specimen surface of a specimen or, in other words, substrate surface from a substrate. Such specimen may be a semiconductor wafer. Specifically, the specimen or wafer may have been etched by a chemical liquid or, in other words, wet chemistry, which may comprise one or more chemical etchants. This may be done by immersion of the specimen into a bath containing the chemical liquid or by dispensing the chemical liquid onto a surface of the wafer, for example. For semiconductor wafers as specimens, a wet etching process is often being used typically for or within wafer thickness reduction, in particular on a backside of the wafer as opposed to a frontside of the wafer. A result of the wet chemistry etching may be that the surface roughness of the specimen surface is changed, in particular in a controlled manner such that it is within a target or target range of surface roughness.

The wet etching may be carried out during the backend-of-the-line (BEOL) stage of the semiconductor manufacturing process. In an exemplary BEOL process for power semiconductor devices employing the wafer, the wet etching may be used for wet chemical surface finishing of the wafers. Typically, tape bonding or using a glass carrier wafer and wafer back grinding are preceding the wet etching. Contact formation, annealing and back side metallization follow the wet etching during the typical BEOL process of semiconductor manufacturing. Hence, the surface roughness may play an important role in the quality of the specimen and hence the device using the specimen, e.g., a (power) semiconductor device.

To measure the surface roughness of a specimen surface of a specimen, it is known to process an image, in particular a real-time image, of the specimen surface. For accurate results, tuning the parameters of the camera capturing the image to eliminate external interferences may be desirable. For example, the reflection characteristics of the specific specimen surface and/or material, e.g., a silicon wafer, may be taken into consideration for tuning or calibrating the camera parameters. However, an accurate determination of surface roughness is still challenging, and it may be desirable to determine the surface roughness as accurate, fast, and reliable as possible, potentially different kinds of specimens, different in particular or at least in terms of size, material and/or reflection characteristics.

**SUMMARY OF THE INVENTION**

The above problem is at least partially solved or alleviated by the subject matters of the independent claims of the present disclosure, wherein further examples are incorporated in the dependent claims.

According to a first aspect of the present disclosure, there is provided a method for determining a surface roughness of a specimen surface of a specimen, the method comprising:

- obtaining several measurement data, each one of the measurement data being indicative of a surface topology of the specimen surface based on an optical three-dimensional measurement of the specimen surface by an image sensor, wherein each one of the measurement data is associated with a different brightness level of a light source illuminating the specimen surface or with a different exposure of the image sensor;
- obtaining first computation data indicative of surface roughnesses of the specimen surface for each one of the measurement data; and
- determining second computation data indicative of a surface roughness of the specimen surface for all (of the several) measurement data based on the first computation data.

The method of this disclosure provides for accurately, quickly and reliably determining a surface roughness of a specimen surface of a specimen by using several measurement data of several measurements, the several measurements being different in a measurement parameter of the optical three-dimensional measurement, namely a brightness level of a light source that is being used or an exposure of the image sensor, and computing the several measurement data from the several measurements in a way such that an accurate surface roughness of the specimen surface is determined for all measurement data or all measurements, which may reflect a single accurate value of surface roughness as a result of the method. In other words, first, several measurements of the specimen surface may be performed by the image sensor employing an optical three-dimensional measurement of the specimen surface and providing, as a result thereof, the measurement data, which is indicative of a surface topology of the specimen surface. For example, each one of the measurement data may be indicative of or comprise surface topology data, e.g., in the form of a three-dimensional (surface topology) image or cloud point data. For each of the several measurements and thus for each of the several measurement data, a different brightness level of a light source illuminating the specimen surface during the measurement, i.e., capturing the image of the specimen surface by the image sensor, may be used. Alternatively, a different exposure of the image sensor may be used for each of the several measurements and thus for each of the several measurement data. Second, first computation data may be obtained, in particular determined or computed, more particularly by a data processing system, which is indicative of the surface roughnesses, in particular values of surface roughness, for the specimen surface for each one of the several measurements or several measurement data. In particular, each of the surface roughnesses or values of surface roughness may be different based on the observation that the different brightness levels or the different exposures produce different surface roughness values. Third, based on the first computation data, second computation data may be determined, in particular computed, more particularly by the data processing system, based on the first computation data and reflecting a surface roughness, in particular value of surface roughness, representing all measurements or measurement data, which may be an accurate single surface roughness or surface roughness value of the entire specimen surface. This method is reliable because when it is performed for several specimens it produces reproducible results, in particular independent of the size, material, and reflection characteristics of different specimens (e.g., shiny or rough specimen surfaces), by using measurement data with varied brightness levels of the light source or varied exposures of the image sensor.

The method of the first aspect may in particular be an at least partially or fully computer implemented method. This means that at least one, multiple or all of the steps of the method may be carried out by a data processing system, which may comprise one or more data processing apparatuses or computers or computing units, which may be part of a system for performing the wet etching process or, in other words, wet etching processing system. Different steps may be carried out by the same or by different computers. A computer is herein understood as a data processing apparatus, which can carry out some, multiple or all steps as defined by the method. The one or more computers may be configured as or provided inside of one or more sensor units, control units and/or other units of the specimen processing system or separate therefrom but as part of the specimen processing system. The one or more sensor unit may be the one having the image sensor. For example, the sensor unit may be configured as a camera unit having the image sensor and/or the light source.

The obtaining of the several measurement data may be performed by the data processing system, for example. Alternatively, or additionally, the obtaining of the several measurement data may be performed by the sensor unit or camera unit, which may send the several measurement data to the data processing system. Alternatively, or additionally, the method of this disclosure may, in addition to obtaining the several measurement data, comprise measurement of the measurement data, e.g., by the sensor unit or camera unit of the specimen processing system. The measurement data may be or comprise image data, in particular showing the three-dimensional surface topology, e.g., in a coordinate system, and/or a point cloud representing the points of the three-dimensional surface topology, for example.

The obtaining of the first computation data and/or the determining of the second computation data may be performed by the data processing system, for example. In particular, the first computation data and/or the second computation data may be based on a computation by the data processing system, wherein the computation of the first computation data is based on the several measurement data as input and/or the computation data of the second computation data is based on the first computation data.

For obtaining, in particular determining, the first computation data, for example, a computational method, simulation or formula may be used for determining the surface roughnesses or surface roughness values of the specimen surface, using each one of the measurement data as input. The method, simulation or formula may be configured such that the surface roughness is determined in terms of the physical characteristics or based on the principles of physics considering the specimen surface. Depending on the value representing the surface roughness to be computed or calculated, the mathematical method or formula may vary. For example, as value of the surface roughness, an average or arithmetic average of profile height deviations from a mean line (typically referred to as Ra, Raa, or Ryni) may be used. Such average or arithmetic average, Ra, may be for example used for any of the surface roughnesses indicated by the first computation data or the second computation data. Additionally, or alternatively, other values or metrics representing the surface roughness, such as but not limited to a quadratic mean or root mean square average of profile height deviations from the mean line (typically referred to as Rq or RMS), a maximum valley depth below the mean line (typically referred to as Rv), a maximum peak height above the mean line (typically referred to as Rp), a maximum peak to valley height of the profile, a skewness, kurtosis, average distance between the highest peak and lowest valley, a value based on a number, e.g., five, highest peaks and/or lowest values, an ISO grade number, and/or any other value may be used. The computational method, simulation or formula may vary for each one of the aforementioned examples of values or metrics.

For determining the second computation data, the surface roughnesses of each one of the several measurement data may be combined with one another in any one of different ways as described further below.

The specimen may for example be a wafer, in particular a semiconductor wafer. The semiconductor wafer may be used to fabricate integrated circuits. In particular, the wafer may be etched at its backside opposing its frontside. The wafer may have any reflective or reflection characteristic. The wafer may comprise Silicon, in particular crystalline Silicon, or any other semiconductor material such as but not limited to Germanium, Gallium arsenide, Indium phosphide, Silicon carbide, or Gallium nitride or Sapphire. The specimen may be of any size and geometry. The specimen may for example be disc-shaped. The specimen may alternatively be referred to as a substrate, in particular a disc-shaped substrate. The specimen may alternatively be any other substrate than a wafer, e.g., a metal substrate or glass substrate.

The optical three-dimensional measurement may for example be based on white light interferometry. In other words, white light interferometry may be used for the optical three-dimensional measurement. A camera having the image sensor may be part of a setup for the white light interferometry. The image sensor may be a charge-coupled device (CCD) image sensor, for example. The light source may be a white light source, for example. The white light interferometry is particularly accurate where surfaces vary in the range of nanometres, e.g., 50 nm to 500 nm, such as may be the case with wafer surfaces.

Each one of the measurement data may be associated with different brightness levels or different exposures being increased or decreased in increments between consecutive measurements by the image sensor. Accordingly, for example, the several measurements or several measurement data may be consecutively obtained by varying the brightness levels or exposures by consecutively increased or decreased increments. The increments may be predetermined or predefined. For example, the increments may be predetermined or predefined as absolute and/or relative increments, e.g., in % of a nominal brightness level or nominal exposure. For example, the increments may be fixed, in particular fixed values throughout all measurements. Alternatively, the increments may vary throughout the measurements, e.g., having smaller or larger increments in the first measurements compared to later measurements, or varying in any other way.

For example, the increments may be (sized or in their size) in the range of 0,1 % to 8 %, in particular in the range of 0,5 % to 6 %, more particularly in the range of 1 % to 4 %, of a nominal brightness level or a nominal exposure. The nominal brightness level or nominal exposure may be defined by the technical limitations of the light source and/or image sensor, for example. The nominal brightness level or nominal exposure may be a maximum brightness level or maximum exposure. The exposure may also be referred to as an exposure ratio or exposure value. The exposure may for example define the amount of light per unit area, e.g., $mm^2$, reaching the surface of the image sensor. The nominal or maximum exposure may for example be the maximum amount of light per unit area the image sensor may register or make use of. It has been found that the increments within this range provide accurate results of the surface roughness indicated by the second computation data with at least acceptable or fast determination times.

Alternatively, or additionally, for example, the increments may be (increased or decreased, in particular with their size) between 5 % or more, in particular 10 % or more, of the nominal brightness level or the nominal exposure and 80 % or more, in particular 90 % or more, more particularly approximately or exactly 100 %, of the nominal brightness level or the nominal exposure. It has been found that thereby the substantially fully useful or sensible range of different brightness levels or exposures may be employed to provide accurate results of the surface roughness indicated by the second computation data with at least acceptable or fast determination times.

By defining the size of the increments and the relative range in terms of the nominal brightness level or the nominal exposure in which the increments are increased or decreased, the number of measurements or measurement data, in particular of images captured of the specimen surface by the image sensor, may be defined. For example, the number of several measurements, measurement data and/or images may be in the range of 10 to 900, in particular in the range of 20 to 900, more particularly in the range of 20 to 180, and even more particularly in the range of 40 to 120, e.g., 90, in increments of 1 % of the nominal brightness level or the nominal exposure between 10 % and 100 % of the nominal brightness level or the nominal exposure, for example. These numbers have been found to be advantageous as the data gained thereby is sufficient to gain accurate second computation data while the method may be conducted relatively fast.

One of the brightness level and the exposure may for example be maintained substantially constant or approximately constant between the consecutive measurements by the image sensor. In other words, while one of the brightness level and the exposure is increased or decreased over the consecutive measurements, the other one may be maintained constant. It has been found, that varying only one of the aforementioned measurement parameters is sufficient to produce a set of several measurements for determining a single accurate surface roughness value. This simplifies the method and provides for very fast determination of the roughness value for all of the several measurement data as opposed to when both measurement parameters would be varied, which may be however a possibility, either consecutively, simultaneously or at random, for example.

The method may (further) comprise:

- filtering each one of the measurement data by one or more of: removing data points outside of the specimen surface, removing noise, cropping an image representative of the surface topology as indicated by the measurement data, and leveling of the image;

wherein the first computation data may be based on each one of the filtered measurement data. In other words, filtered measurement data for each one of the measurement data may be generated before obtaining the first computation data, which is then obtained based on the filtered measurement data. The filtering improves the accuracy of the first computation data and thereby the second computation data because values, data points or similar are filtered from the several measurement data, which would otherwise result in inaccurate results of the second computation data, e.g., because they are based on noise, outliers or otherwise not accurately reflecting the specimen surface. For example, when removing data points outside of the specimen surface, e.g., within the image or point cloud, spikes may be removed from the image or point cloud, e.g., line by line. Further, or alternatively, for example, when removing noise, the surface as represented by the image or point cloud may be smoothed, e.g., by mean filtering. Further, or alternatively, for example, by cropping the image that represents the surface topology, image padding on the borders of the image may be avoided. Further, or alternatively, for example, by leveling the image, the rough surface in the image may be separated from the rest of the surfaces, whereby waviness of the image may be removed. For example, for the filtering of each one of the measurement data as described herein or as an alternative, the ISO 25178 norm may be at least partially or fully used, in particular with respect to all of the herein mentioned filtering measures.

For example, determining the second computation data may comprise computing a density function for each one of the surface roughnesses of the specimen surface for each one of the measurement data and determining the surface roughness of the specimen surface for all measurement data based on the density function. In particular, the density function may indicate the probability for different surface roughness values from the first computation data as based on the several measurement data. In particular, the density function may be a probability density function indicating the probability of the surface roughness values within a range of surface roughness values based on the surface roughness values of the first computation data. For example, the density function may be plotted as probability, e.g., in % or point values, over surface roughness, e.g., in nm. Interestingly, it has been found that by computing the density function for the surface roughnesses of each one of the several measurement data, a pronounced maximum or, in other words or when graphically representing the density function, peak may be observed over the range of the different brightness levels or different exposures.

Hence, for example, the surface roughness of the specimen surface for all measurement data may be determined based on or as a maximum of the density function. The surface roughness, in particular the single surface roughness value, for all measurement data, may be the maximum or peak of the density function or approximately or near the maximum or peak of the density function, e.g., a mean around the peak or similar, for example.

The determining of the second computation data may for example comprise repeating the obtaining of the several measurement data, the first computation data and determining the second computation data if the computed density function is indicative of two peaks of surface roughness of the specimen surface for all measurement data. More specifically, for example, the aforementioned steps of the method may be repeated if both peaks meet a peak threshold and/or both peaks differ from one another in size within a peak threshold. The two or even more peaks, in particular when meeting the peak threshold and thereby being of similar or sufficient size, may be interpreted as a signal for repeating the method for determining the surface roughness of the specimen surface. For example, but not limited thereto, a dust particle or similar may be the root cause of the two peaks or maxima in the density function. If after repeating the aforementioned steps, there are still two peaks present, the measurement or specimen may be rejected, e.g., treated as a scrapped part.

It is noted that the determination of the second computation data may be alternatively or additionally performed in a different manner than using a density function or different than choosing a maximum or peak of the density function. Any other function or method, e.g., determining a mean or arithmetic or other value from the surface roughnesses of the specimen surface for each one of the measurement data or of the density function are examples for such a different manner.

For example, the specimen surface may be an etched specimen surface. Further, the method may comprise:

- obtaining control data for controlling one or more settings of a wet etching process to be carried out on one or more further specimens based on the second computation data.

Thereby, the method may provide for controlling the wet etching process by controlling one or more settings of the wet etching process based on the second computation data accurately reflecting the measurement data. In particular, the control data may be obtained for controlling one or more settings of the wet etching process for the etching of further specimens following the already etched specimen or specimens, which have been previously measured, by the same wet etching process, in particular with the same container containing the chemical liquid that has been used for etching the previous specimens. Thereby, the method does not rely on potentially inaccurate statistical methods to perform the wet etching process of the specimens as fast as possible, with as little resources as needed, e.g., wet chemistry, eliminating too early exchange thereof, and with constant quality, e.g., with a substantially constant target surface roughness range. Instead, the method uses actual measurement data of one or more parameters, in particular target parameters of the wet etching process relating to a target size of the etched specimens or before and after the etching of the specimens and/or quality parameters of the wet etching process associated with a quality of the etched specimens, the quality in particular relating to a size or dimensional tolerance or accuracy of all etched specimens with respect to one or more of the parameters. However, besides using the surface roughness indicated by the second computation data, it may be possible to use alternative or additional measurement data of one or more other parameters, e.g., of a measured thickness or material removal of the specimen, for determining the control data. In other words, measurement data indicative of a thickness and/or material removal of the specimen by the wet etching may be alternatively or additionally used for basing the obtaining of the control data thereon.

The obtaining of the control data may be performed by the data processing system, for example. Alternatively, or additionally, the obtaining of the control data may be performed by one or more control units and/or one more operational units configured to carry out the one or more control settings, the unit(s) being of the wet etching processing system. In the additional variant of the aforesaid, the data processing system may provide the control data to the one or more control units and/or one or more operational units to be obtained by it or them, and to be carried out consequently. For example, the one or more control and/or operational units may be configured for exchanging the chemical liquid at least partially, changing a composition of the chemical liquid, e.g., by adding one or more chemical etchants to the chemical liquid, and/or for controlling the etching duration of specimens. For example, the operational units may be or comprise any of, but not limited to, a dispenser or dispensing unit for dispensing the chemical liquid onto a surface of the specimen, a pump fluidically connected to the dispenser and a container, a feed line into the container of the wet etching processing system, the container containing the chemical liquid, and similar.

Alternatively, or additionally, the method of this disclosure may, in addition to obtaining the control data, comprise carrying out the control data, i.e., the one or more settings to be controlled, e.g., by the one or more control units and/or the one or more operational units of the wet etching processing system. The obtaining of the control data may be a determining of the control data, in particular by the data processing system. As described further below, the obtaining of the control data may also be an updating of the control data, in particular of already obtained or existing control data.

Herein, the controlling of the one or more settings may for example mean that one or more settings are determined or set, e.g., the lifetime of the wet chemistry or, in other words, chemical liquid. Alternatively, or additionally, for example, the controlling of the one or more settings may mean adjusting current or currently set settings, e.g., a setting relating to a lifetime for exchanging the chemical liquid, by adjusting it, e.g., reducing or extending the lifetime, such that an exchange of the chemical liquid in the container may be triggered earlier or later depending on the second computation data. Further examples of control of settings are given below and the control in the examples of the determination or setting and adjustment as described may mutually apply to these settings.

The wet etching process may be a single specimen etching process, in which single specimens may be consecutively etched by dispensing the chemical liquid onto a specimen surface of the specimen. For example, the chemical liquid may be dispensed, e.g., dropped, sprayed or similar, by a nozzle, spraying system or similar dispensing unit of the wet etching processing system onto the specimen surface of the specimen, in particular a side, more particularly a backside, of a wafer. The specimen may be optionally rotated during the dispensing of the chemical liquid or wet etching process for better distribution of the chemical liquid on its surface. An opposing surface may not be needed or must not be subjected to the chemical liquid, in which case a gas stream or similar may be supplied to or at that side, preventing that the chemical liquid reaches that side, in particular the frontside of the wafer. The single specimen etching process may be performed by a type of wet etching processing system, which may be referred to as a single specimen wet etching processing system. Only one specimen at a time may be etched, at least within one processing chamber or device for etching, as opposed to when multiple specimens are etched, e.g., by means of batch etching, in which multiple specimens may be placed into a carrier and dipped into a bath of chemical liquid. However, batch etching or other forms than single specimen etching may alternatively be implemented.

The second computation data may be consecutively determined for specimens etched by the wet etching process and the control data may be, in particular consecutively, obtained or updated based on the second computation data. For example, every single consecutive specimen or every few consecutive specimens may be measured for obtaining the second computation data. In particular, a sampling or sampling mode may be used, according to which a predetermined sample number and/or sample order is used for obtaining second computation data for specimens according to the sample number and/or the sample order. The sample number may indicate, for example, the number of samples per chemical liquid, per number of specimens, e.g., 100, and/or similar, to be measured. The sample order may indicate the specimens to be measured within the consecutive specimens, e.g., every few consecutive specimens, such as, for example, every 2, 5 or 10 specimens, or a varying, e.g., fixedly varying, or dynamically adopted, number of every few consecutive specimens. The sampling, in particular the sample number and/or sample order, may be dependent on the type, e.g., material, and/or size of wafer, on the type and/or composition of the chemical liquid being used, on the second computation data from the previously measured etched specimens and/or on the (previously) obtained control data, for example. By obtaining or updating the control data based on each one of these second computation data, the wet etching process may be constantly monitored during the wet etching processing of the specimens. In particular, the wet etching process may be monitored such that when the second computation data indicates a quality change of one or more consecutive specimens, e.g., the etched specimens departing from the target range of one or more of the target parameters or coming closer to thresholds of the target range, the control data may be updated to control the one or more settings, e.g., by adjusting a setting and/or determining or setting a new setting, to counter the quality change, in particular quality decrease, for example by exchanging the chemical liquid in the container at least partially or substantially fully (meaning that some remainder or residue of the previous chemical liquid may still be contained in the container but the most part of the chemical liquid may be replaced).

For example, at least one of the one or more settings may relate to an at least partial exchange of the chemical liquid. The at least partial exchange of the chemical liquid may also be a full or substantially full exchange of the chemical liquid contained in the container of the wet etching processing system (meaning that some remainder or residue of the previous chemical liquid may still be contained in the container but the most part of the chemical liquid may be replaced). For example, the setting relating to the exchange of the chemical liquid may indicate a time, in particular a lifetime, after which the chemical liquid is to be replaced at least partially, in particular with the same type and/or composition of chemical liquid. Additionally, or alternatively, for example the setting relating to the exchange of the chemical liquid may indicate an amount or substance, e.g., the one or more chemical etchants, of the chemical liquid to be exchanged. By providing a new or fresh chemical liquid or wet chemistry, e.g., as a bath inside the container, the active chemicals, or substances, e.g., the one or more chemical etchants, are once again present and/or able to etch the specimen within the target parameter or parameters to meet the thereby set quality requirements of the specimen.

Additionally, or alternatively to the at least partial exchange of the chemical liquid, for example, at least one of the one or more settings may relate to a change of an etching duration. The etching duration may mean the (total) duration of the etching of the specimen in the wet etching process and may be determined by or correspond or substantially correspond to the dispensing time and/or amount of the chemical liquid to be dispensed per specimen, for example. Hence, for example, by adjusting, determining and/or setting the dispensing time and/or amount of the chemical liquid to be dispensed per specimen, the etching quality may be maintained constant within the target parameter(s). For example, the dispensing time may be increased over the lifetime of the wet chemistry such that an increasingly chemically weaker or less reactive wet chemistry in terms of etching rate may still deliver specimens with the target parameter(s) being in the target range at the costs of increased etching duration and thereby increased processing time per specimen. However, this may be tolerated as a trade-off before exchanging the chemical liquid, for example, and help to maintain the quality control of the etched specimen.

Additionally, or alternatively to the at least partial exchange of the chemical liquid and/or the change of the etching duration, for example, at least one of the one or more settings may relate to a change of a composition of the chemical liquid. For example, the one or more chemical etchants, other chemical substances, and/or additional etchants (other than the one or more chemical etchants in the chemical liquid) may be added to the chemical liquid to change the composition of the chemical liquid. This may also be referred to as spiking or buffering with the respective chemical substance, e.g., etchant. Thereby, less effective or ineffective chemical etchant, which may already have reacted with the specimen, e.g., oxidized, such as but not limited to for example hydrofluoric acid (HF), may be filled up within the container containing the chemical liquid before triggering a substantially full exchange of the chemical liquid or increasing the etching duration to undesired levels. In addition, or alternatively, a proportion or amount of water in the chemical liquid may be determined.

Additionally, or alternatively to the at least partial exchange of the chemical liquid, the change of the etching duration and/or the change of the composition of the chemical liquid, for example, at least one of the one or more settings may relate to a change of distribution of the chemical liquid on the specimen. For example, a dispensing profile of the dispensing of the chemical liquid on a surface of the specimen may be adjusted to change the distribution of the chemical liquid on the specimen. For example, the dispensing profile may comprise a pattern of dispensed chemical liquid per time. Alternatively, or additionally, a dispensing direction, a rotation speed and/or direction of the specimen, or similar may be adjusted to change the distribution of the chemical liquid on the specimen. Based on the second computation data, the change of distribution may thereby for example be used to provide a more uniform thickness and/or surface roughness distribution on the surface of the specimen.

The method may for example further comprise:

- obtaining second measurement data indicative of a composition of the chemical liquid,

wherein the control data is further based on the second measurement data. In particular, the amount of the one or more chemical etchant in the chemical liquid may be indicated by the second measurement data. The second measurement data may be based on, obtained or determined by a measurement unit of the wet etching processing system, e.g., an optical spectrometer. Hence, the measurement data indicative of the surface topology of the specimen surface based on the optical three-dimensional measurement of the specimen surface by the image sensor may also be referred to herein as first measurement data. By having the second measurement data and basing the control data thereupon, the control data may be obtained such that it takes into consideration the composition of the chemical liquid, e.g., the amounts of different chemical substances, such as chemical etchants and other surfaces, e.g., including chemically reacted or less effective or ineffective amounts of chemical etchant(s), e.g., oxidized etchant(s), inside the chemical liquid. This may be useful because the first measurement data can be linked to the composition of the chemical liquid and, for example, if the amount of chemically active or effective, e.g., oxidizing, chemical etchant(s) is low in the chemical liquid, a deviation of one or more of the target parameters from a target range can be attributed to the composition and the control data may accordingly be obtained or updated, e.g., by changing the composition of the chemical liquid by adding one or more chemical etchants.

The control data may be further based on threshold data, the threshold data being indicative of a threshold for the surface roughness of the specimens. The threshold may indicate or provide or be associated with the target or target range for the respective target parameter of surface roughness. Thereby, it may be ensured that the target parameter may be kept within the desired target range. For example, when the target parameter is outside of the threshold, e.g., exceed or are below it (depending on the threshold definition), the control data may be obtained or updated to control the one or more settings. The control data may be dependent on the quantity by which the threshold or thresholds, i.e., the target or target range, is or are exceeded or fallen below by the target parameter(s). For example, the one or more settings, e.g., etching duration, may be controlled in correlation, e.g., proportionally, to the quantity of exceedance or falling below of the threshold(s).

Alternatively, or additionally, the control data may be at least partially or fully obtained as output of a machine learning algorithm, the machine learning algorithm being trained at least with the second computation data and/or the control data from previous wet etching processes. The previous wet etching processes may have used different chemical liquids or wet chemistries, e.g., not necessarily in terms of composition but rather with the same composition but chemically used up in terms of their reactiveness for the etching processing during the previous wet etching processes and exchanged by fresh chemical liquid. Hence, the machine learning algorithm, which may be executed by the data processing system, may have learned or have been trained based on at least the second computation data and/or the control data to obtain or update the control data as output of the machine learning algorithm in an optimized way based on the previous historical data of the previous wet etching processes. For example, in the previous wet etching processes, different and/or same types and/or sizes of specimen may have been used and the machine learning algorithm may have learned the optimal or near-optimal control of the one or more settings of the control data based on the different specimen. Also, or alternatively, the previous wet etching processes may have controlled different settings and/or different quantities in the settings, e.g., etching durations or amounts of etchant added to fill up the chemical liquid container, may have been used and the machine learning algorithm may have learned the optimal or near-optimal settings to be controlled in terms of determining or setting them and/or their quantity, for certain measurement data, e.g., a specific total thickness variation range, such that the machine learning algorithm knows and delivers as output the one or more settings to be controlled in a way, such that they optimally deal with the certain measurement data, e.g., a specific total thickness variation range.

It is noted that the basing of the control data on the threshold data, which may be based on a deterministic approach as opposed to a machine learning approach, does not necessarily exclude the machine learning algorithm approach. To the contrary, both may be used in combination, e.g., by having both obtaining the control data and choosing therefrom, or combining both, or in any other way. Further, other or additional ways of obtaining the control data may be employed, such as neural networks or other artificial intelligence methods, for example.

The method may be configured for controlling two or more wet etching processes, in particular each one using a different chemical liquid, and wherein the method comprises obtaining control data for each one of the two or more wet etching processes. Also, the second computation data may be determined for each one of the two or more wet etching processes. By means of two or more wet etching processes, the etching of the specimen may be improved. The two or more wet etching processes are in particular carried out consecutively for each one of the specimens. For example, one of the wet etching processes may be used for preparation of the specimen surface to be etched. For example, for this wet etching process, HF may be used as chemical liquid. Then, or alternatively, one of the wet etching processes may be used for polish etching of the surfaced of the specimen. Here, for example, a different chemical liquid (in terms of its composition), e.g., containing HNO3, HF, H2SO4 and H3PO4, may be used. Then, for example, a wet etching process may be used for rough etching of the surface of the specimen. Here, again, a different chemical liquid may be used, e.g., containing HNO3, HF, H2SO4. Hence, each wet etching process processes the surface of the specimen differently based on the used chemical liquid or wet chemistry composition and can be attributed with the aforesaid intentions, i.e., preparation, polishing, and rough etching. Using the method for controlling each one of the two or more, in particular consecutive, wet etching processes, for each one of the different chemical liquids, allows to optimize the quality of the specimen based on controlling the one or more settings in each one of the two or more wet etching processes based on second computation data for or after each one of the wet etching processes. Hence, one could say that the method is applied for every consecutive wet etching processing with a different or the same chemical liquid composition for the same specimen surface.

According to a second aspect of this disclosure, there is provided a computer program product comprising instructions which, when the program is executed by a computer or data processing apparatus, cause the computer or data processing apparatus to carry out the method according to the first aspect of this disclosure.

The computer program product may be a computer program, in particular as such, meaning a computer program consisting of or comprising a program code to be executed by the computer or data processing apparatus. Alternatively, the computer program product may be a product such as a data storage, in particular a computer-readable data storage medium, on which the computer program may be at least temporarily or permanently stored.

According to a third aspect of this disclosure, there is provided a data processing system configured to carry out the method according to the first aspect of this disclosure.

The data processing system may comprise one or more computers or data processing apparatuses as previously described and, optionally, the computer program product of the second aspect of this disclosure.

According to a fourth aspect of this disclosure, there is provided a specimen processing system, the specimen processing system comprising the data processing system of the third aspect of this disclosure, a light source for illuminating the specimen surface, and an image sensor for obtaining the several measurement data.

The specimen processing system may in particular be configured as a wafer processing system for processing wafers, in particular as a wet etching system or, in other words, a system for performing a wet etching process.

For example, the specimen processing system may comprise a container for containing a chemical liquid for wet etching specimens, and a dispenser fluidically connected to the container for dispensing the chemical liquid onto a specimen surface of the specimens from the container.

The image sensor and light source may be part of a measurement system of the specimen processing system. Moreover, the measurement system may comprise a measurement unit for obtaining the second measurement data, e.g., in the form of an optical spectrometer. Further, the wet etching processing system may comprise a chamber or device for containing the specimen during the dispensing of the chemical liquid onto the specimen surface. Moreover, a rotation unit may be provided in the wet etching processing system for rotating the specimen during the dispensing of the chemical liquid. Further, the wet etching processing system may comprise a feed line, pump and/or similar fluidically connecting the dispenser with the container. Similarly, a drain line, pump and/or similar may be provided in the wet etching processing system to fluidically connect a drain section of the chamber or device with the container to allow drainage of the chemical liquid used for etching the specimen in the chamber or device therefrom and recirculation to the container.

If two or more different wet etching processes are being used, in particular each one using a different chemical liquid, the wet etching processing system may comprise two or more container for each one of the different chemical liquid. Further, the wet etching processing system may comprise separate chambers or drain sections inside one chamber or device for draining and recirculating each one of the different chemical liquids separately to their respective container. Also, the wet etching processing system may comprise an actuator for moving the specimen between the at least two chambers or drain sections, e.g., which may also be rotatable or rotatably connected to the rotation unit, for example, e.g., in the form of a linearly moveable axis to move the specimen between the two chambers or drain sections.

It is noted that the above aspects, examples and features may be combined with each other irrespective of the aspect involved.

The above and other aspects of the present disclosure will become apparent from and elucidated with reference to the drawings described hereinafter.

## BRIEF DESCRIPTION OF THE DRAWINGS

Exemplary embodiments will be further described with reference to Figures, wherein:

Figure 1 shows a perspective view of a specimen processing system according to an example.

Figure 2 shows a schematic illustration of the specimen processing system of Fig. 1 with its components.

Figure 3 shows a perspective view of a processing chamber of the specimen processing system of Figs. 1 and 2 while etching a wafer.

Figure 4 shows a schematic illustration of a BEOL process of a semiconductor manufacturing process.

Figures 5 and 6 show schematic illustrations of the result of different settings controlled during different etching processes as shown in Fig. 4 in terms of quality of the wafers as herein defined.

Figure 7 shows a schematic illustration of a method for controlling the wet etching processes of Fig. 4 and its result in terms of quality of the wafers as herein defined.

Figures 8 shows a schematic illustration of a method for determining a surface roughness of a specimen surface of a specimen inside the specimen processing system of Figs. 1 and 2.

Figure 9 and 10 show schematic illustrations of the results of optical three-dimension measurement of the specimen surface with different brightness levels.

Figure 11 shows a schematic illustration of a calculated roughness of the specimen surface for multiple optical three-dimension measurements at different brightness levels.

Figure 12 shows a schematic illustration of a calculated roughness of the specimen surface for multiple optical three-dimension measurements at different exposure ratios.

Figure 13 shows a schematic illustration of using kernel density estimation for calculation of surface roughness.

Figure 14 shows a schematic illustration of a density function for the optical three-dimension measurements at different brightness levels of Fig. 11.

Figure 15 shows a schematic illustration of a density function for the optical three-dimension measurements at different exposure ratios of Fig. 12.

The Figures are schematic only and not true to scale. In principle, identical or like parts, elements and/or steps are provided with identical or like reference numerals in the Figures.

## DETAILED DESCRIPTION OF THE INVENTION

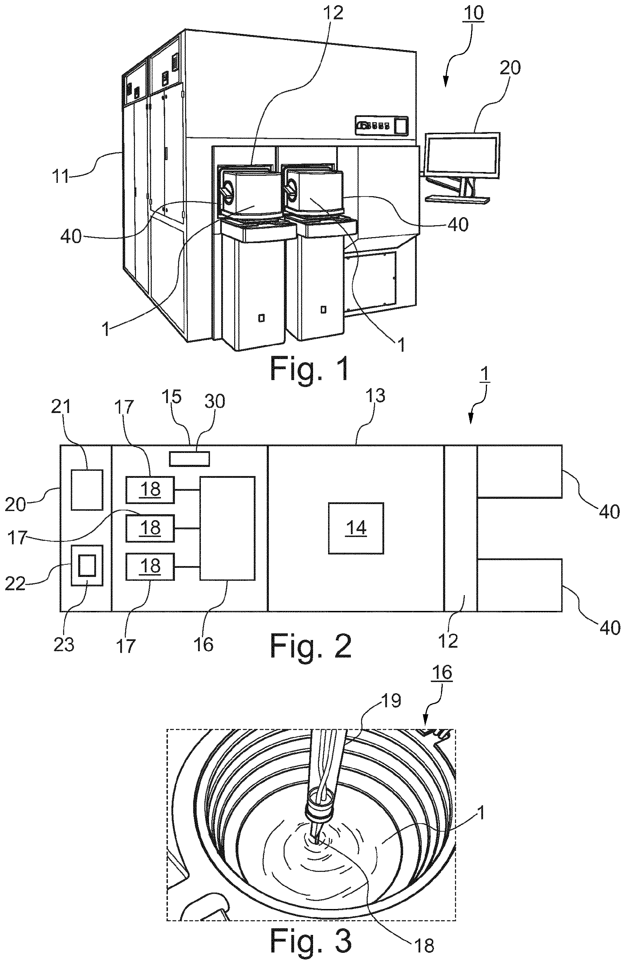

Figure 1 shows a perspective view of a specimen processing system 10, herein embodied exemplary as a wet etching processing system 10 or, in other words, a system for carrying out a wet etching process 10 according to an example. However, alternatively, or additionally, any other processing of the specimen 1 may be provided for by the system 10. The specimen processing system 10 of this example comprises a housing 11 and an obtaining section 12 for obtaining specimens 1, in this exemplary case semiconductor wafers 1 (see Fig. 3).

As shown in Fig. 1, the wafers 1 may be obtained from respective containers 40 containing the wafers 1 (as indicated in Fig. 1). Merely as an example, two containers 40 are shown herein, however, the number of containers 40 may be less or more. For example, one or more of the containers 40 may be containing the wafers 1, which have not yet been processed by the system 10, in particular not have been wet etched, and one or more other containers 40 may be obtaining or receiving the wafers 1 after their processing or wet etching by the system 10.

Additionally, the system 10 comprises a data processing system 20, herein shown exemplary with a monitor and interface for receiving input from a human operator. The data processing system 20 is exemplary shown outside of the housing 11 but may be alternatively positioned also inside the housing 11 and without the monitor and interface, for example.

Figure 2 shows the specimen processing system 10 in a schematic illustration. Generally, any system, section and similar as shown in system 10 is merely shown herein in position, size and number only schematically and can be located, sized or in number different than shown. The wafers 1 to be etched are received from one or more of the shown containers 40 through the obtaining section 12, e.g., an opening inside the housing 11, and in particular by a handling section 13. The handling section 13 may comprise one or more handling means 14, such as one, two or more robotic arms, for example, for handling the wafers 1. In particular, the handling means 14 may provide the wafers 1 to be etched to a processing section 15, in which a chamber 16 or device may be located for etching the wafers 1. In particular, there may be several processing sections 15 and/or chambers 16 or devices. For example, the wafers 1 may be parallely processed by the respective sections 15 and/or chambers 16. Similarly, the one or more handling means 14 may receive the wafers 1 again once they have been etched and provide them inside of the one or more other containers 40 for receiving the processed wafers 1.

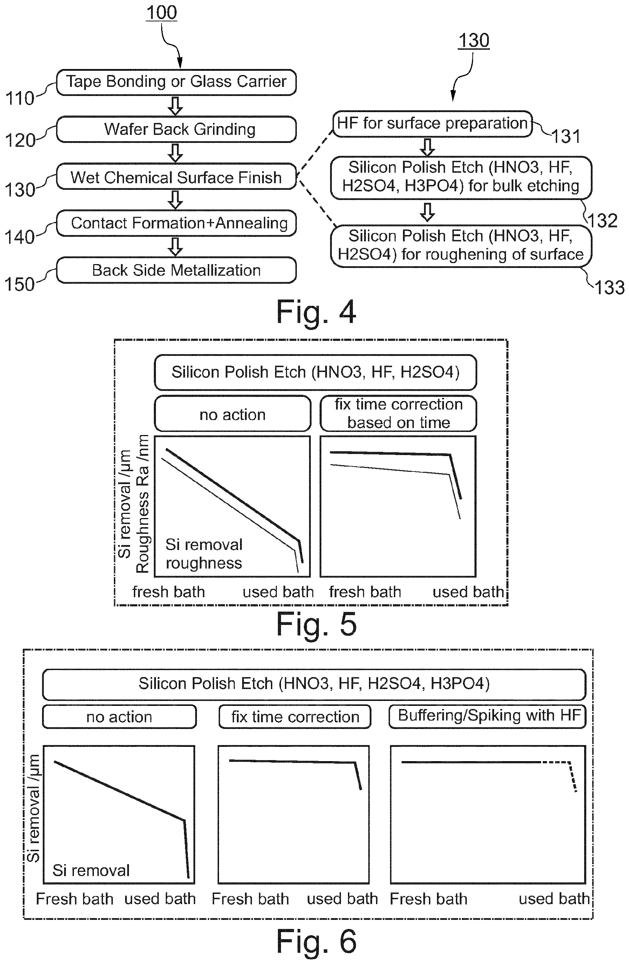

The chamber 16 or device may be supplied with chemical liquid 18 comprising one or more chemical etchants for etching the wafers 1. The chemical liquid 18 may be contained inside one or more containers 17 or, in other words, tanks for containing the chemical liquid 18. The containers 17 may for example be in the range of one to four. The containers 17 may be located inside the system 10, in particular the housing 11, or externally thereof, for example, and connected to the system 10, e.g., via hoses. The chemical liquid 18 may also be herein referred to as a bath or bath of chemical liquid 18. In particular, different chemical liquid compositions may be provided inside of two or, as exemplary shown, three or more containers 17 for different chemical etching processes 131, 132, 133 as exemplary explained hereinafter with reference to Fig. 4.

The specimen processing system 10, e.g., in the processing section 15, may further comprise one or more measurement systems 30, which may comprise one or more sensor units, including one or more camera units, in particular one or more image sensors and one or more light sources, for obtaining first measurement data indicative of a material removal, a thickness and/or a surface roughness of one or more of the wafers 1 etched by the chemical liquid(s) 18 after one, more or each one of the wet etching processes 131, 132, 133. Optionally, the measurement system 30 may also comprise a measurement unit for obtaining second measurement data indicative of a composition of the chemical liquid(s) 18 inside the container(s) 17, e.g., in the form of an optical spectrometer.

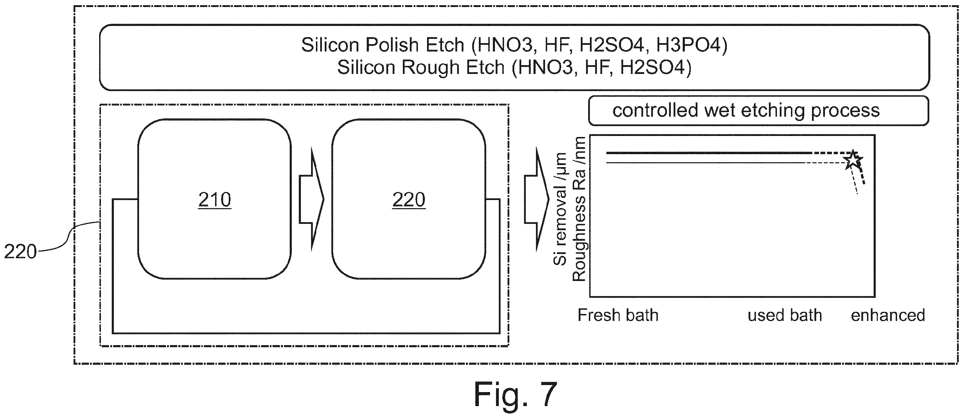

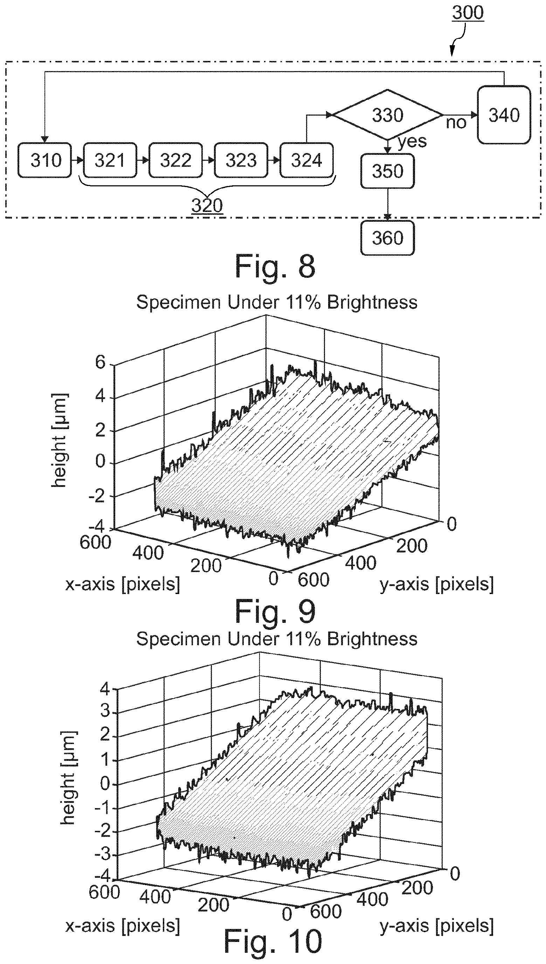

Further, as shown in Fig. 2, the data processing system 20 may comprise a data processing apparatus 21, e.g., in the form of one or more computers or computing units. Moreover, the data processing system 20 may comprise a computer program product 22 in the form of a computer readable storage medium 22, on which a computer program product 23 in the form of a computer program 23 may be stored. When the data processing apparatus 21 carries out the instructions of the computer program 23, the method 200 as shown in Fig. 7 and will be explained hereinafter may be executed. Alternatively, or additionally, when the data processing apparatus 21 carries out the instructions of the computer program 23, the method 300 as shown in Fig. 8 and will be explained hereinafter may be executed. Also, separate computer programs 23 may be provided for method 200 and method 300, for example.

Figure 3 shows a perspective view of the processing chamber 16 of the specimen processing system 10. In this example, the wet etching is shown as a single wafer etching process, in which single wafers 1 are consecutively etched by dispensing the chemical liquid 18 onto their surface. However, alternatively, any other type of wet etching processing using a chemical liquid 18, e.g., batch etching, may be used as explained hereinbefore. In this example, the chemical liquid 18 is delivered, e.g., pumped, to a dispenser 19, e.g., in the form of a nozzle, dispensing the chemical liquid 18 onto a surface, in particular frontside, of the wafer 1 provided inside the processing chamber 16. Accordingly, a feed line, pump and/or similar may be provided inside the processing section 15 and connecting the containers 17 with the chamber 16, in particular the dispenser 19 therein. Also, there may be a drain line provided at the containers 17 for draining the chemical liquid 18 therefrom. For example, the wafer 1 may be rotated during the dispensing of the chemical liquid 18 by a rotation unit (not shown), which may, for example, be disposed underneath the wafer 1 and driven by an actuator, e.g., an electric motor. Moreover, as may be seen from Fig. 3, the wafer 1 may be elevated to different levels or drain sections of the processing chamber 16, e.g., for consecutive wet etching with the different chemical liquids 18, e.g., also by an actuator such as an electric motor or the same actuator.

Figure 4 schematically illustrates a backend-of-the-line (BEOL) process 100 of a semiconductor manufacturing process. In the exemplary shown BEOL process for power semiconductor devices employing the wafer 1, the wet etching may be used for wet chemical surface finishing 130 of the wafers 1. Typically, tape bonding or using a glass carrier wafer 110 and wafer back grinding 110 are preceding the wet etching surface finishing 130. Contact formation and annealing 140 and back side metallization 150 may follow the wet etching during the typical BEOL process 100 of semiconductor manufacturing.

Further, as shown for the wet chemical surface finishing 130, for example, three different etching processes 131, 132, 133 may be conducted consecutively, wherein each one of the three different chemical liquids 18 as shown in Fig. 2 may be used, thereby differentiating the wet etching processes 131, 132, 133 from one another. For example, a first wet etching process 131 may be used for preparation of the surface of the wafer 1 to be etched. For example, for this wet etching process, HF may be used as chemical liquid 18. A second wet etching process 132 may be used for polish etching of the surfaced of the wafer 1. Here, for example, a different chemical liquid 18 (in terms of its composition), e.g., containing $HNO_3$, HF, $H_2SO_4$ and $H_3PO_4$, may be used. A third wet etching process may be used for rough etching of the surface of the wafer 1. Here, again, a different chemical liquid 18 may be used, e.g., containing $HNO_3$, HF, $H_2SO_4$. Hence, each wet etching process 131, 132, 133 processes the surface of the wafer 1 differently based on the used chemical liquid 18 or wet chemistry composition and can be attributed with the aforesaid intentions, i.e., surface preparation, polishing, and rough etching.

Figure 5 shows a schematic illustration of the etching result of a setting named fix time correction based on time controlled during the wet etching process 133 as shown in Fig. 4. Specifically, the left graph in Fig. 5 shows that, as the bath of the chemical liquid 18 in the respective container 17 for the silicon rough etch for roughening of the surface gets older through usage over time, the removal of Silicon (Si) in $\mu$m and the roughness Ra in nm become less with every wet etched wafer 1, in particular in a linearly decreasing manner. Herein, the roughness Ra is exemplary chosen as an average or arithmetic average of profile height deviations from a mean line. That is because the chemical liquid 18 is altering over lifetime during the wet etching process 133 of the wafers 1, in particular due to the chemical reaction of the chemical liquid 18 with the material of the wafer 1, e.g., Si, in effect consuming or rendering less effective or ineffective the etchant(s) inside the chemical liquid 18. The altering of the wet chemistry over lifetime can change the etching results of the wafers 1 consecutively etched over the lifetime of the wet chemistry, when using the same chemical liquid 18 during the wet etching process 131.

Thus, the bath of chemical liquid 18 may need to be replaced in order to maintain a desired consistency of Si removal and roughness throughout the wafers 1 etched by the same bath of chemical liquid 18. However, an alternative action may be the fix time correction based on time. A control setting of this action may be to change the etching duration, thereby correcting the time based on the usage time of the bath of the chemical liquid 18 so far. For example, the time that the chemical liquid 18 is dispensed on each of the wafers 1, may be increased with increased usage time of the bath, thereby increasing the time the chemical liquid 18 can etch the surface of the wafer 1. As seen in the right graph of Fig. 5, this effectively reduces the decrease in Si removal and roughness over usage time of the bath and thereby allows to control the etching quality of the wafers 1 etched over time using the same bath, i.e., the consistency of the etching results.

Figure 6 shows a schematic illustration of the etching result of a setting of fix time correction, as explained hereinbefore with reference to Fig. 5, and of a setting of buffering or spiking of the chemical liquid 18 with a chemical etchant, herein HF, during the wet etching process 132 as shown in Fig. 4. The left graph in Fig. 6 shows that, as the bath of the chemical liquid 18 in the respective container 17 for the silicon rough etch for roughening of the surface gets older through usage over time, the removal of Si in $\mu$m becomes less with every wet etched wafer 1, in particular in a linearly decreasing manner. Thus, the bath of chemical liquid 18 needs to be replaced in order to maintain a desired quality of Si removal and roughness. However, an alternative action may be the fix time correction based on time as shown in the middle graph and explained hereinbefore with reference to Fig. 5. A control setting of this action may be to change the etching duration, thereby correcting the time based on the usage time of the bath of the chemical liquid 18 so far. In particular, the time that the chemical liquid 18 is dispensed on each of the wafers 1, may be increased with increased usage time of the bath, thereby increasing the time the chemical liquid 18 can etch the surface of the wafer 1. As seen in the middle graph of Fig. 6, this effectively reduces the decrease in Si removal and roughness over usage time of the bath and thereby allows to control the quality of the wafers 1 etched over time using the same bath. An alternative control action may be the buffering or spiking with a chemical etchant, herein HF as an example, as shown in the right graph in Fig. 6. The thereon based control setting may be the change of the composition of the chemical liquid 18, e.g., by adding HF as chemical etchant, thereby buffering or spiking the chemical liquid 18 with HF. As shown in the right graph, this may even further enhance the Si removal consistency over the usage time of the bath of the chemical liquid 18.

Figure 7 shows a schematic illustration of a method 200 for controlling any, multiple or all of the wet etching processes 131, 132, 133 of Fig. 4 (on the left of Fig. 7) and its etching result (on the right of Fig. 7). For example, the method 200 is referred to in Fig. 7 to be performed for the wet etching processes 132 and 133, which may be carried out consecutively.

In a first step 210 of method 200, measurement data is obtained, which is indicative of a material removal, e.g., Si in μm, a thickness, e.g., thickness of the wafer in mm or similar, and/or a surface roughness, e.g., Ra in nm, of the wafer 1 etched last by the respective chemical liquid 18 used for that wet etching process 132 or 133. This step may be in particular carried out by the data processing system 20 and/or the measurement system 30. For example, the measurement system 30 may obtain the measurement data through measurement and forward it to the data processing system 20, where it is thereby obtained and may be further processed, in particular for the second step 220, which may follow the first step 210.

In the second step 220, based on the measurement data, control data for controlling one or more settings of the respective wet etching process 132, 133, after which the measurement data has been obtained for the thereafter etched wafer 1, is obtained, in particular determined, by the data processing system 20. For example, the one or more settings may be the change of the etching duration, e.g., fixe time correction as explained hereinbefore, the change of composition of the chemical liquid 18, e.g., buffering or spiking with HF as explained hereinbefore, and/or an at least partial or full exchange of the chemical liquid 18, i.e., changing a part or entirety of the bath of chemical liquid 18 inside the container 17 for the respective wet etching process 132, 133.

In particular, the method 200 may be performed twice, once for wafers 1 after the wet etching process 132 and once for wafers 1 after the wet etching process 133, thereby obtaining control data for controlling one or more settings of each one of the wet etching processes 132, 133. Thereby, after each wet etching process 132, 133, the settings thereof may be controlled such that the result is optimized as seen in the right part of Fig. 7. There, it is shown that by controlling the wet etching processes 132, 133, the Si removal and Roughness may be kept constant or substantially constant for a very long period of bath usage and this quality control may even be enhanced, in particular by using a mix of the aforementioned settings, e.g., by first changing the etching duration, afterwards changing the composition of the chemical liquid 18 and finally changing the chemical liquid 18 or,. In other words, bath, as marked by the star in the graph.

Further, as shown in Fig. 7, the method steps 210 and 220 may be repeated, for example for each or every few wafers 1 processed by the wet etching process 132 and/or the wet etching process 133, thereby continuously monitoring the bath or chemical liquid 18 by means of the measurement data of the wafers 1 and updating the control data when necessary or beneficial.

When using the measurement data as obtained from the measurement system 30 for the method 200 or any other purpose, e.g., any other method for quality control assurance, the measurement data received directly from the measurement system 30 may not be accurate enough for providing the high etching quality as shown in Fig. 7 or, at least, it may be desirable to increase the accuracy of the measurement data. That is because the measurement data, e.g., the surface roughness indicated thereby, may not be an accurate or reproducible measurement value for different types of wafers 1, e.g., having shiny or rough surfaces.

To measure the surface roughness of the specimen 1, it is known to process an image, in particular a real-time image, of the specimen surface. For accurate results, tuning the parameters of the camera capturing the image to eliminate external interferences may be desirable. For example, the reflection characteristics of the specific specimen surface and/or material may be taken into consideration for tuning or calibrating the camera parameters. However, an accurate determination of the surface roughness is still challenging but it is highly desirable to determine the surface roughness as accurate, fast, and reliable as possible, potentially different kinds of specimens 1, different in particular or at least in terms of size, material and/or reflection characteristics, so that for example the method 200 provides for high etching quality results.

For this purpose, the method 300 schematically illustrated in Figure 8 may be carried out, in particular separate from, as part of or in addition to the method 200 of Fig. 7, for example. Method 300 is configured for determining the surface roughness of a specimen surface of a specimen 1, in particular wafer 1, inside the system 10.

The measurement system 30 and/or the data processing system 20 is or are configured to obtain several measurement data, each one of the measurement data being indicative of a surface topology of the wafer surface based on an optical three-dimensional measurement of the wafer surface, in particular by the same image sensor, wherein each one of the measurement data is associated with a different brightness level of the light source illuminating the wafer surface or with a different exposure of the image sensor. For obtaining the several measurement data, the steps 310, 320, 330 and 340 of the method 300 are repeated several times.

Specifically, in step 310, the optical three-dimensional measurement of the specimen surface by the image sensor may be carried out with a certain brightness level of the light source or with a certain exposure of the image sensor. The optical three-dimensional measurement may be based on white light interferometry. For example, the method 300 may be started with 10 % or 11 % brightness level (compared to a nominal, e.g., maximum, brightness level) of the light source or 10 % or 11 % of an exposure ratio (compared to a nominal, e.g., maximum, exposure ratio) of the image sensor. The result of the optical three-dimension measurement at 11 % brightness level is exemplary shown in Fig. 9, illustrating the surface in three dimensions, i.e., height (in µm), x-axis and y-axis (in pixels). A similar result may be obtained for 11 % exposure ratio (not shown).

Then, optionally, in step 320, the measurement data obtained from step 310, i.e., indicative of or comprising the optical three-dimensional measurement at the certain brightness level or exposure ratio, may be filtered, for example according to ISO 25178 norm. For example, in sub-step 321, data points outside of the specimen surface may be removed. Further, for example, in sub-step 322, noise may be removed. Moreover, for example, in sub-step 323, the image representative of the surface topology as shown in Fig. 9 may be cropped. Also, for example, the image may be levelled in sub-step 324.

Then, in step 330, it is determined whether the brightness level or exposure ratio is at a predetermined threshold or level. If not, the method 300 continues with step 340, in which the brightness level or exposure ratio is increased in a predefined increment, e.g., of 1% or less or more, and the steps 310 to 330 and/or 340 are repeated. There while, the respective other parameter, i.e., brightness level or exposure ratio, may be kept constant, e.g., at 100 % or any other value. Hence, the several measurement data obtained thereby is associated with different brightness levels or exposures increased in increments until a predefined threshold or limit, e.g., 100 % of brightness level or exposure, is reached, such as it is exemplary shown for 100 % of brightness level in Fig. 10. Hence, if the outcome of step 330 is that the threshold or level is reached, the method 300 continues with steps 350 and 360.

Generally, after determining the outcome of the step 330 of being yes or at every step 330 or any other step or between any steps of the method 300, the method 300 may comprise obtaining, in particular by the data processing system 20, first computation data indicative of a surface roughness of the specimen surface for each one of the measurement data. In other words, a surface roughness value, e.g., as an average or arithmetic average of profile height deviations from a mean line (Ra), may be determined, in particular calculated, for each one of the several measurement data, i.e., the surface topology from the optical three-dimensional measurement at a certain brightness level or exposure. Hence, for each one of the measurements, there may be one calculated surface roughness value associated with the measurement.

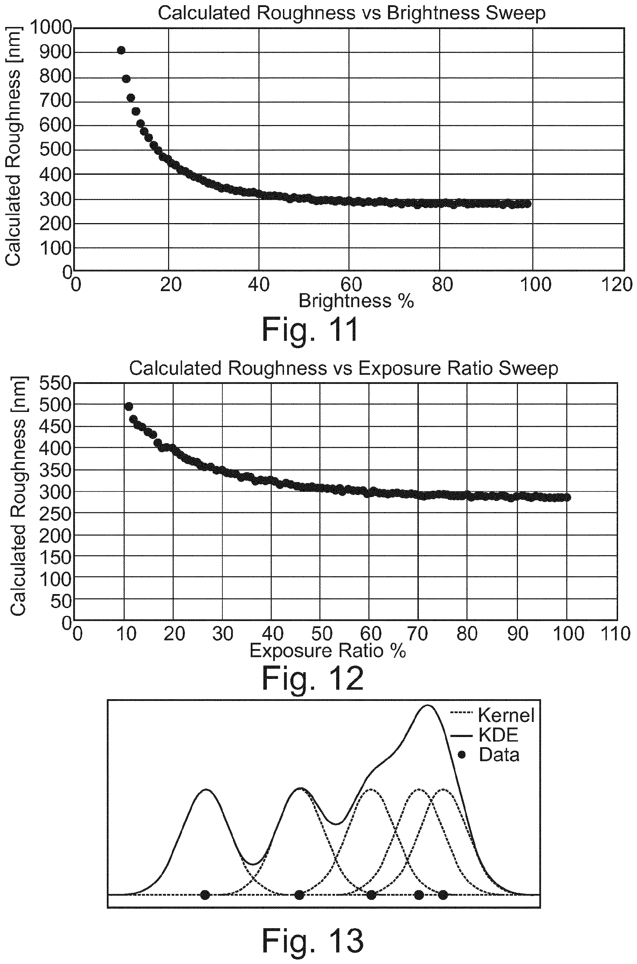

The calculated roughness values are shown in Fig. 11 for the increase of brightness level in %. The repetition of steps 310 to 330 and/or 340, i.e., measuring the surface topology and filtering the measurement data and potentially increasing the brightness level or exposure by an increment, is herein also referred to as a sweep, in particular a brightness sweep for the increased brightness level or exposure ratio sweep for the increased exposure ratio. Fig. 12 shows the calculated roughness values if the same specimen surface is measured but with different exposure ratios instead of different brightness levels. In both cases, the measurements are performed within a range of 10 to 100 % of the respectively increased parameter. One can see that the calculated roughness values fluctuate significantly depending on the brightness level or exposure ratio being used. It is noted that the results also depend on the reflective characteristics of the measured specimen or wafer 1, i.e., a rather shiny wafer 1 will have other reflective characteristics than a wafer 1 being less shiny or rough, and hence, it is not simply possible to calibrate the image sensor to a certain brightness level or exposure ratio, at which the results would be comparable to each other for different wafer surfaces.

Further, as shown in Figs. 11 and 12, the brightness and exposure ratio sweep lead to almost the same specimen roughness result in the end. The relevant difference between brightness and exposure ratio is the measurement duration. For the exposure ratio sweep, the measurement duration was found to be approx. 2.5 minutes while the measurement duration for the brightness level sweep was found to be approx. 52 seconds. The reason behind this is that brightness can be updated on the fly during the measurement acquisition while the exposure ratio needs the whole image sensor or camera to be configured again, which takes almost 3 times more than the brightness approach.

After the obtaining of the first computation data, generally, second computation data may be determined, in particular by the data processing system 20, the second computation data being indicative of a surface roughness of the specimen surface for all measurement data based on the first computation data. In other words, the surface roughness values of every single measurement data are combined into a single surface roughness value representing an accurate surface roughness value of the specimen surface.

For determining the second computation data, the method 300 may comprise, at step 350, computing a density function for each one of the surface roughnesses of the specimen surface for each one of the measurement data and, at step 360, determining the surface roughness of the specimen surface for all measurement data based on the density function. For computing the density function, for example, a kernel density estimation (KDE) as exemplary shown in Fig. 13 may be used.

Specifically, the KDE may be applied to the whole result list of calculated roughness values collected to calculate the specimen roughness for all measurement data. KDE is a statistical method that estimates a random variable's probability density function (PDF). Unlike histograms, which divide data into bins, KDE may produce a smoother representation of the data's distribution.

For every data point $x_i$, e.g., measurement taken, a kernel function $K(x - x_i)$ may be placed, which may generally be a smooth and symmetric function, like a Gaussian function. Then the kernel function is placed at the centre of each data point. The kernel function's width is then determined by selecting a bandwidth "h". The greater bandwidth the smoother the estimate result, while a narrower bandwidth produces a more accurate but potentially a bit noisy estimate. The final step is summing up these kernel values for all observed data points. This yields the contribution of all data points to the density estimate at point "x" as shown in Figure 13.

$$Estimated\ Density\ at\ x\ (Peak) = \frac{1}{n}\sum_{i=1}^{n} K\left(\frac{x-x_i}{h}\right)$$

Hence, it follows that: , where n is the number of observed data points, K is the kernel function, and h is the bandwidth.

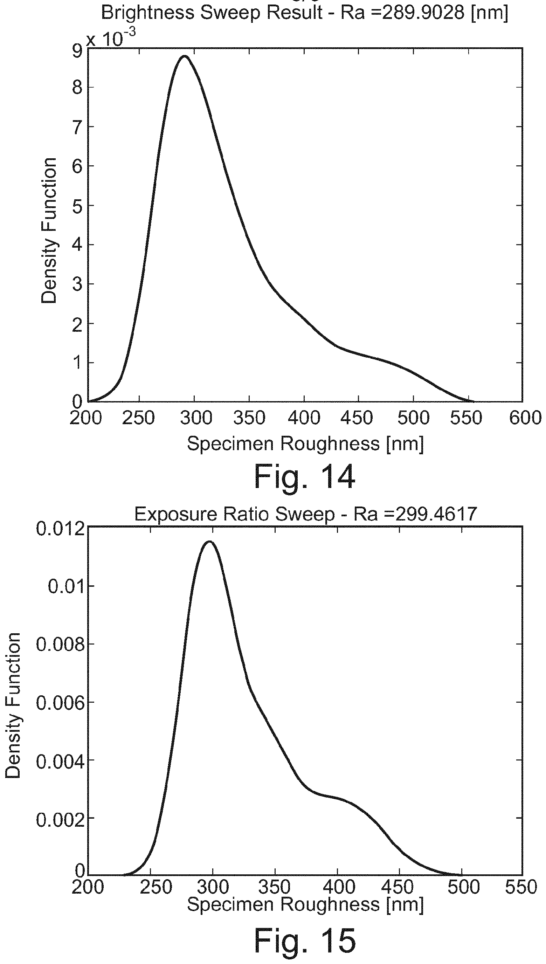

Figures 14 and 15 show the result of the method 300 in form of a graph of the density function over the specimen roughness value for the brightness sweep (Fig. 14) and the exposure ratio sweep (Fig. 15). Both, brightness sweep and exposure ratio sweep deliver similar results of the surface roughness of the specimen surface, namely approx. 289 and approx. 299 nm. Specifically, the peak of the graph may be determined to be the surface roughness of the specimen surface for all measurement data as indicated or comprised by the second computation data.

Optionally, three regions of interest may be observed, a region left of the peak, a region under the peak and a region right of the peak. First, the left region of the peak may be seen as the under exposure region where the light is not enough for the specimen 1, then light is increased until the second region is reached. The second area is the area exactly under the peak, which may be considered as a well exposure region, in which all the valid calculations are being captured at this region. Then, light is still increasing until the third region of over exposure is reached, where the light is more than what the specimen 1 needed. The higher the accuracy of the roughness calculation the higher the density peak in the well exposure range.

Eventually, there is no need any more to tune parameters that can work for the roughness calculation. The method 300 with the brightness or exposure ratio sweep works with any kind of wafer surface whether shiny or rough. The peak and thereby the accurate surface roughness will be detected regardless of the specimen reflectivity.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practicing the claimed invention, from a study of the drawings, the disclosure, and the claims.

As used herein, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Further, as used herein, the phrase "at least one" or similar, e.g., "one or more of', in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that such entities may optionally be present other than the entities specifically identified within the list of entities to which the phrase "at least one" or similar refers, whether related or unrelated to those entities specifically identified. Thus, as a non-limiting example, "at least one of A and B" (or, equivalently, "at least one of A or B" or, equivalently "at least one of A and/or B" or, equivalently "one or more of A and B", "one or more of A or B", or "one or more of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

As used herein, the phrase "being indicative of' may for example mean "reflecting" and/or "comprising". Accordingly, an entity, element and/or step referred to herein as "being indicative of [...]" can be synonymously or interchangeably used herein with one, two or all of said entity, element and/or step "comprising [...]" and said entity, element and/or step "reflecting [...]".

Further, as used herein, phrases such as "based on", "related" or "relating", "associated" and similar are not to be seen exclusively in terms of the entities, elements and/or steps to which they are referring, unless otherwise stated.

Instead, these phrases are to be understood inclusively, unless otherwise stated, in that, for example, an entity, element or step referring by any of these phrases or similar, e.g., being "based on", an or another entity, element or step, does not exclude that the respective entity, element or step may be further or also "based on" any other entity, element or step than the one to which it refers.

The designation of methods and steps as first, second, etc. as provided herein is merely intended to make the methods and their steps referenceable and distinguishable from one another. By no means does the designation of methods and steps constitute a limitation of the scope of this disclosure. For example, when this disclosure describes a third step of a method, a first or second step of the method do not need to be present yet alone be performed before the third step unless they are explicitly referred to as being required per se or before the third step. Moreover, the presentation of methods or steps in a certain order is merely intended to facilitate one example of this disclosure and by no means constitutes a limitation of the scope of this disclosure. Generally, unless no explicitly required order is being mentioned, the methods and steps may be carried out in any feasible order. Specifically, the terms first, second, third or (a), (b), (c) and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

In the context of the present invention any numerical value indicated is typically associated with an interval of accuracy that the person skilled in the art will understand to still ensure the technical effect of the feature in question. As used herein, the deviation from the indicated numerical value is in the range of $\pm$ 10%, and preferably of $\pm$ 5%. The aforementioned deviation from the indicated numerical interval of $\pm$ 10%, and preferably of $\pm$ 5% is also indicated by the terms "about" and "approximately" used herein with respect to a numerical value.

Any reference signs in the claims should not be construed as limiting the scope.

**Claims**

1. A method (300) for determining a surface roughness of a specimen surface of a specimen (1), the method (300) comprising:

   - obtaining several measurement data, each one of the measurement data being indicative of a surface topology of the specimen surface based on an optical three-dimensional measurement of the specimen surface by an image sensor, wherein each one of the measurement data is associated with a different brightness level of a light source illuminating the specimen surface or with a different exposure of the image sensor;
   - obtaining first computation data indicative of surface roughnesses of the specimen surface for each one of the measurement data; and
   - determining second computation data indicative of a surface roughness of the specimen surface for all measurement data based on the first computation data.

2. The method (300) of claim 1, wherein the specimen (1) is a wafer (1).

3. The method (300) of claim 1 or 2, wherein the optical three-dimensional measurement is based on white light interferometry.

4. The method (300) of any one of the previous claims, wherein each one of the measurement data is associated with different brightness levels or different exposures being increased or decreased in increments between consecutive measurements by the image sensor.

5. The method (300) of claim 4, wherein the increments are:

   ∘ sized in the range of 0,1 % to 8 % of a nominal brightness level or a nominal exposure, and/or
   ∘ between 5 % or more of the nominal brightness level or the nominal exposure and 80 % or more of the nominal brightness level or the nominal exposure.

6. The method (300) of claim 4 or 5, wherein one of the brightness level and the exposure is maintained substantially constant between the consecutive measurements by the image sensor.

7. The method (300) of any one of the previous claims, wherein the method (300) comprises:

- filtering each one of the measurement data by one or more of: removing data points outside of the specimen surface, removing noise, cropping an image representative of the surface topology as indicated by the measurement data, and leveling of the image;

wherein the first computation data is based on each one of the filtered measurement data.

8.  The method (300) of any one of the previous claims, wherein determining the second computation data comprises computing a density function for each one of the surface roughnesses of the specimen surface for each one of the measurement data and determining the surface roughness of the specimen surface for all measurement data based on the density function.

9.  The method (300) of claim 8, wherein the surface roughness of the specimen surface for all measurement data is determined based on or as a maximum of the density function.

10. The method (300) of claim 8 or 9, wherein the determining of the second computation data comprises repeating the obtaining of the several measurement data, the first computation data and determining the second computation data if the computed density function is indicative of two peaks of surface roughness of the specimen surface for all measurement data.

11. The method (300) of any one of the previous claims, wherein the specimen surface is an etched specimen surface, and wherein the method comprises:

- obtaining control data for controlling one or more settings of a wet etching process (131, 132, 133) to be carried out on one or more further specimens (1) based on the second computation data.

12. A computer program product (22, 23), which, when executed by a data processing apparatus (21), instructs the data processing apparatus (21) to carry out the method (300) according to any one of the previous claims.

13. A data processing system (20) configured to carry out the method (300) according to any one of claims 1 to 11.

14. A specimen processing system (10), the specimen processing system (10) comprising the data processing system (20) of claim 13, a light source for illuminating the specimen surface, and an image sensor for obtaining the several measurement data.

15. The specimen processing system (10) of claim 14, wherein the specimen processing system (10) comprises a container (17) for containing a chemical liquid (18) for wet etching specimens (1), and a dispenser (19) fluidically connected to the container (17) for dispensing the chemical liquid (18) onto a specimen surface of the specimens (1) from the container (18).

Fig. 1

Fig. 2

Fig. 3

**Fig. 4**

**Fig. 5**

**Fig. 6**

Fig. 7

Fig. 8

Fig. 9

Fig. 10

Fig. 11

Fig. 12

Fig. 13

Brightness Sweep Result - Ra =289.9028 [nm]

Fig. 14

Exposure Ratio Sweep - Ra =299.4617

Fig. 15

Europäisches
Patentamt
European
Patent Office
Office européen
des brevets

# EUROPEAN SEARCH REPORT

**Application Number**

EP 24 16 9471

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 111 707 221 A (UNIV XIAN TECHNOLOGICAL) 25 September 2020 (2020-09-25) * the whole document * | 1-15 | INV. G01B11/30 |
| A | CA 2 594 010 C (BRITISH COLUMBIA CANCER AGENCY BRANCH [CA]) 17 January 2017 (2017-01-17) * paragraphs [0037] - [0045], [0055]; claims 24, 25; figures 1-11 * | 1-15 | |
| A | ROY T BLUNT: "White Light Interferometry - a production worthy technique for measuring surface roughness on semiconductor wafers", CS MANTECH CONFERENCE, APRIL 24-27, 2006, VANCOUVER, BRITISH COLUMBIA, CANADA, 1 January 2006 (2006-01-01), pages 59-62, XP055349680, * the whole document * | 1-15 | |
| A | CHEN LIANG-CHIA ET AL: "Optical 3-D Profilometry for Measuring Semiconductor Wafer Surfaces with Extremely Variant Reflectivities", APPLIED SCIENCES, [Online] vol. 9, no. 10, 19 May 2019 (2019-05-19), page 2060, XP093194984, ISSN: 2076-3417, DOI: 10.3390/app9102060 Retrieved from the Internet: URL:https://www.mdpi.com/2076-3417/9/10/2060/pdf> [retrieved on 2024-08-13] * pages 4-8 * | 1-15 | **TECHNICAL FIELDS SEARCHED (IPC)** G01B |

The present search report has been drawn up for all claims

| Place of search | Date of completion of the search | Examiner |
|---|---|---|
| Munich | 14 August 2024 | Marani, Roberta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    ................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 9471

This annex lists the patent family members relating to the patent documents cited in  the above-mentioned European search report.
The members are as contained in the European Patent Office EDP file on
The European Patent Office is in no way liable for these particulars which are merely given for the purpose of information.

14-08-2024

| Patent document cited in search report | | Publication date | Patent family member(s) | | Publication date |
|---|---|---|---|---|---|
| CN 111707221 | A | 25-09-2020 | NONE | | |
| CA 2594010 | C | 17-01-2017 | AU | 2005321773 A1 | 06-07-2006 |
| | | | CA | 2594010 A1 | 06-07-2006 |
| | | | US | 2008123106 A1 | 29-05-2008 |
| | | | WO | 2006069443 A1 | 06-07-2006 |

EPO FORM P0459

For more details about this annex : see Official Journal of the European Patent Office, No. 12/82